# EUROPEAN PATENT SPECIFICATION

(11) **EP 3 316 478 B1**
(45) Date of publication and mention of the grant of the patent: **23.11.2022**
(21) Application number: 17198611.0
(22) Date of filing: 26.10.2017
(51) Int. Cl.: H02S 40/38, H02S 20/23, H02S 40/44, H02S 40/42, H02S 20/26, H01L 31/048, H01L 31/049

(54) **ALL-IN-ONE INTEGRATED MULTIFUNCTIONAL TRIPLE POWER MODULE "ITM"**
INTEGRIERTES MULTIFUNKTIONELLES ALL-IN-ONE-DREIFACHLEISTUNGSMODUL "ITM"
MODULE DE PUISSANCE TRIPLE MULTIFONCTIONNEL INTÉGRÉ "ITM" TOUT-EN-UN

(30) Priority: 27.10.2016 EP 16196044
(43) Date of publication of application: 02.05.2018
(73) Proprietor: Saphire Solar Technologies ApS, 1552 Copenhagen V (DK)
(72) Inventor: Safir, Yakov, 1552 Copenhagen V (DK)
(74) Representative: Budde Schou A/S

(56) References cited:
- EP-A2- 0 981 167
- WO-A1-2017/029379
- JP-U- H0 296 751

## Description

The present invention relates to a method and a system for an All-in-one Integrated Multifunctional Triple Power Module "ITM"

### Background of the invention

Photovoltaic cells are well known in the art of energy production for generating electrical power from solar radiation in an environmentally friendly way. Such cells, when installed, require a minimum of maintenance and are therefore very suitable as a distributed source of energy. Photovoltaic cells are typically arranged in modules, which are placed in sunny locations. Popular locations include rooftops and facades of buildings.

Photovoltaic cells are made of semiconductor material and are very fragile. Thus, the solar module should provide a front plate and a back plate of rigid material for protecting the photovoltaic cells. The front plate should be transparent in order to allow solar radiation to reach the photovoltaic cells. The front plate is typically made of glass for providing a transparent and yet structurally stable front plate.

A problem encountered is that the solar modules tend to be quite heavy due to the glass used for the front surface and that thus the number of solar modules which may be safely placed on the roof and/or façade is limited due to the structural capability of the building. In order to increase the effective surface and allow more solar modules to be placed, the building may have to be reinforced or the solar modules may have to be carried by a separate framework, all of which increases the installation costs and reduces the aesthetic appearance of the installation. In some cases, the mounting costs alone amount to two thirds of the total installation costs in which the actual photovoltaic module amount to only one third of the total installation cost. The decrease in prices for photovoltaic modules has made the mounting costs even more important for the future.

The object according to the present invention is thus to reduce the installation costs and increase the aesthetic appearance of the installation by maximising the available surface for solar modules while eliminating the need of separate framework or reinforcing of the building.

A further object according to the present invention is to provide solar module, which provide both electrical and thermal energy.

An advantage of the solar module according to the present invention is that it may be used directly as a roof element and/or a façade element thereby eliminating the need for facade panels and roof tiles etc.

### Prior art

The applicant's own PCT application WO 2010/057978 discloses a high voltage semiconductor based wafer which may be mounted on the façade of a building.

Solar collections that combine photovoltaic panels and solar thermal collectors have been disclosed in the shc solar update newsletter of December 2006 (http://www.iea-shc.org/data/sites/1/publications/2006-12-SolarUpdate.pdf)

The presentation "Reducing solar PV soft costs" of the rocky mountains institute (available at http://www.rmi.org/knowledge-center/library/2013-16_simplebosrpt) discloses some opportunities for reducing the costs for solar module installation.

Japanese utility model JP H0296751 U discloses a solar cell system.

### Description of the invention

The present invention is a PV or PVT solar module or solar panel or solar laminate (hereafter called "Module") which is built by a double plate sandwich, metal structural plate or sandwich. The double plate sandwich "DPS" provides constructional strength to the module so that it can be used with or without other supportive measures such as a glass or aluminium frame.

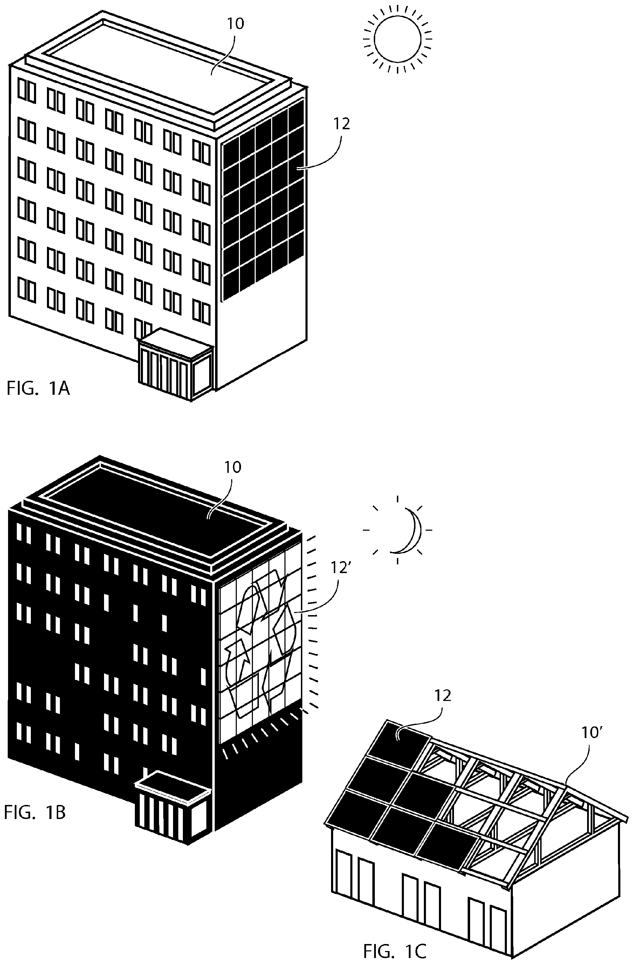

The DPS can consist of a variety of metals or other materials with structural strength such as glass, fiberglass and composite or merged materials in a variety of structural designs. Metals can be e.g. aluminium, stainless steel, iron, copper etc. and mixtures of these. The design of the DPS can be 2 plates, a top and a bottom plate, not necessarily plane, but also curved. The two outer plates form a sandwich where "the inner material" part may be e.g. a sinus plate, a trapezoidal plate, aluminium foam, metal foam, stainless steel foam, a honeycomb structured material, stone wool, Silicon Carbide, Carbon, Fiberglass and or composite or merged materials. Common for all these material designs is that the combination of the bottom plate, and the inner material form a total structure of very high strength. Some structure types are shown in figure 1.

The material layers are either joined together by e.g. glue, silicone, binders, Ethylene Vinyl Acetate "EVA". They can also be joined together by e.g. soldering, welding, bonding, welding by laser, by ultrasonic and by other methods that binds the metal structures strongly together.

Another "DPS" Sandwich type could be a combination of metal & plastic or metal & glass or plastic & glass or of metal & plastic & glass. The DPS layers could also be one top plate, inner material, one middle plate, inner material and a bottom plate. All combinations that in common have the potential of forming a structure that provides a physically strong module. Strong in the meaning solid and firm, so that the module for example will resist bending, braking, stretching, deformation and can bear a load.

On the rear and the front of the DPS are laminated or encapsulated Photovoltaic cells and/or a thermal absorber. The actual DPS can also consist of a thermal absorber structure.

### Definitions and possible components of the sandwich in the present invention.

"Interconnected Solar Cells" = An array of solar cells that are connected electrically together in strings and the cells or strings being interconnected via metal busbars and via bypass diodes. The bypass diodes are laminated in the same layer as the solar cells.

"The top front sheet" is defined as a sheet that is the outer front cover. It can have a plane or textured surface structure. It may consist of any a combination of the materials: metal (aluminium, steel, iron, Cu etc.), glass, Stone Wool, Silicon Carbide, Carbon and Fiberglass. It could also consist of a DPS.

"The back rear sheet" is defined as a sheet that is the outer back cover. It can have a plane or textured surface structure. It may consist of any a combination of the materials: metal (aluminium, steel, iron, Cu etc.), glass, Stone Wool, Silicon Carbide, Carbon and Fiberglass

### Further DESCRIPTION of the invention

The position of the DPS can vary for different PV or PVT module types. One type could consist of the following layers:
(1) A transparent top front sheet layer (made of glass, plastic or DPS), EVA layer, interconnected solar cells layer, EVA layer, DPS layer, EVA layer, plastic, glass or DPS layer.
   Other PV or PVT types could be
(2) A transparent DPS top front sheet layer, EVA layer, interconnected solar cells layer, EVA layer, plastic, glass or DPS layer.
(3) A transparent top front (glass, plastic or DPS) sheet layer, EVA, interconnected solar cells layer, EVA layer, plastic layer, EVA layer, DPS layer, EVA layer, plastic layer or DPS.
(4) A transparent DPS top sheet, EVA, interconnected solar cells layer, EVA, plastic layer, EVA DPS, EVA, plastic layer.

The present invention relates to renewable energy modules, building elements and constructions that enable utilizing several beneficial functions within the same physical area. The present invention of all-in-one integration of several functions into a single modular element/panel dramatically reduces the total system costs. The modular all-in-one element of the present invention is hereafter called "Hercules ITM" and can consist of a DPS. The name Hercules refer to the fact that the construction is very strong. The name ITM refers to the invention being for an All-in-one Integrated Multifunctional Triple Power Module. This all-in-one single ITM element/module/panel is to be compared to standard modular elements/panels, which require several separately produced units in order to deliver and fulfil all the same functions and benefits. For standard state of the art units/panels each function requires a separate mounting construction, each function requires a separate allocated area, each energy conversion requires a separate element/panel e.g. for harvesting energy and converting it to electricity, and/or a separate element for converting solar light efficiently into heating energy etc.

The size of one ITM unit can vary from a very small 100 cm2 for indoor power generating module to very large 20 m2 power modules. Several modules can be interconnected and thus form a system. As an example: if a building needs a 1000m2 roof, the ITM can provide an all-in-one lightweight roof element, an ITM unit that can be the actual roof building block. The roof will thus consist of 50 pieces ITM's, each at 20 m2, and each ITM will include the integrated built-in all-in-one functions including: architectural design, PV electrical generator, solar thermal absorber energy generator, night sky cooling energy generator, programmable Light Emitting Diodes, sensors, valves, insolation layer, battery storage, mounting fixing structure and hot/cold water storage.

Another example could be a 1000m2 facade, in which case the ITM could have the same multifunctional elements built-in, but instead of being a roof building element, the ITM becomes a wall or façade building element.

A third example could be a 20,000 m2 ITM power plant either ground-mounted or mounted on an existing roof. In this case the main built in multifunctional features would be the high gains from the three built-in all-in-on renewable energy generators, generating electrical energy and heat energy in the daytime and cooling energy during the night via black body sky radiation. But all the before-mentioned multiple functions could also be included, although in this example the ITM element is not in itself a building integrated element but is adapted on the building or the ground.

### Mounting units

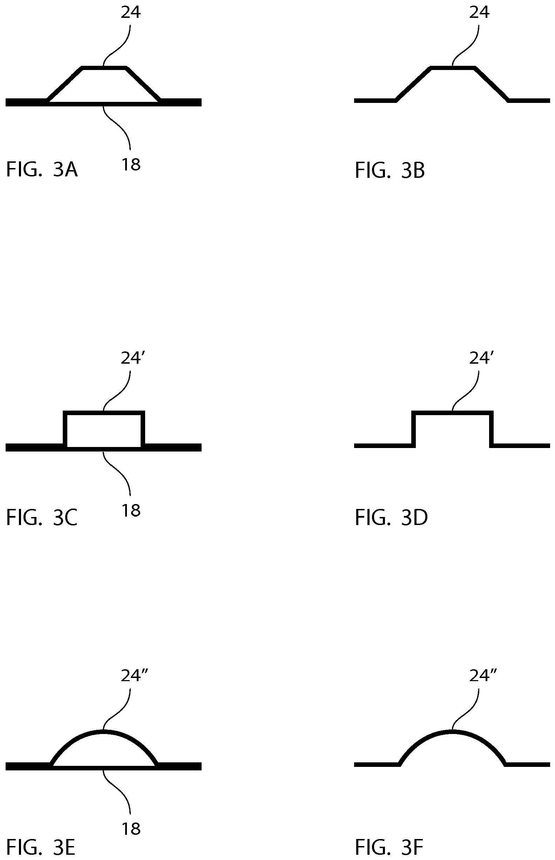

In the present invention, the DPS and ITM can be mounted via a laminated metal or a hard material profile, hereafter called "Omega". The Omega has flaps and possible cross-sections as shown in figure 3, but is not limited to this. Several Omegas can be fixed inside the DPS or ITM.

On the rear of the structure, the flaps are laminated or fixed inside the rear part of the Module or DPS. This provides a very strong adhesion to the Omega. Thus after manufacturing of the Module after the DPS or ITM has been produced with the Omega inside, the Omega can be screwed into or attached with other mounting elements, so that the Module can be attached to facades or roofs or any building unit. The mounted attachment can be via rails or bolted or screwed or welded into the facade.

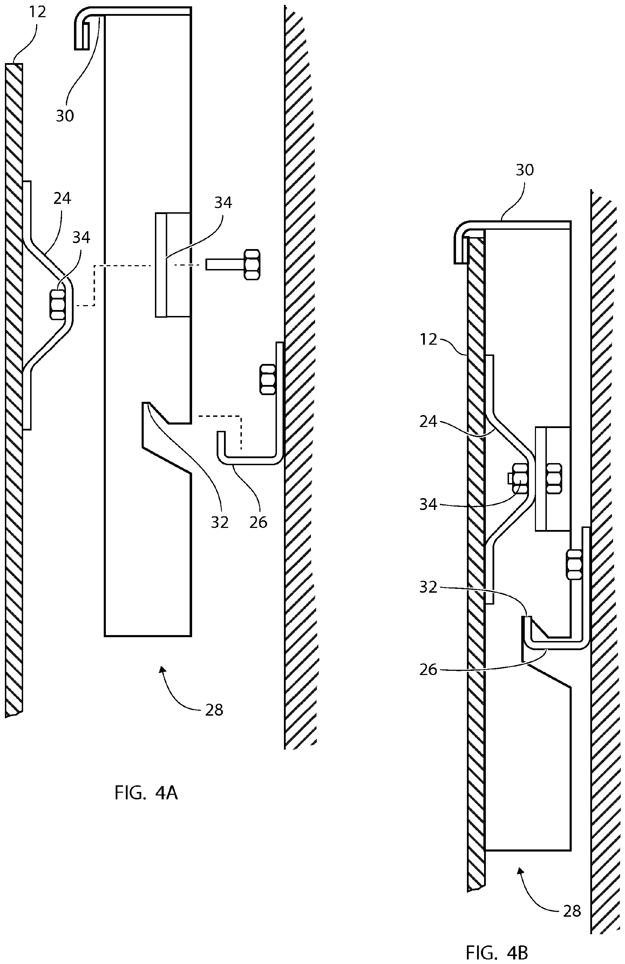

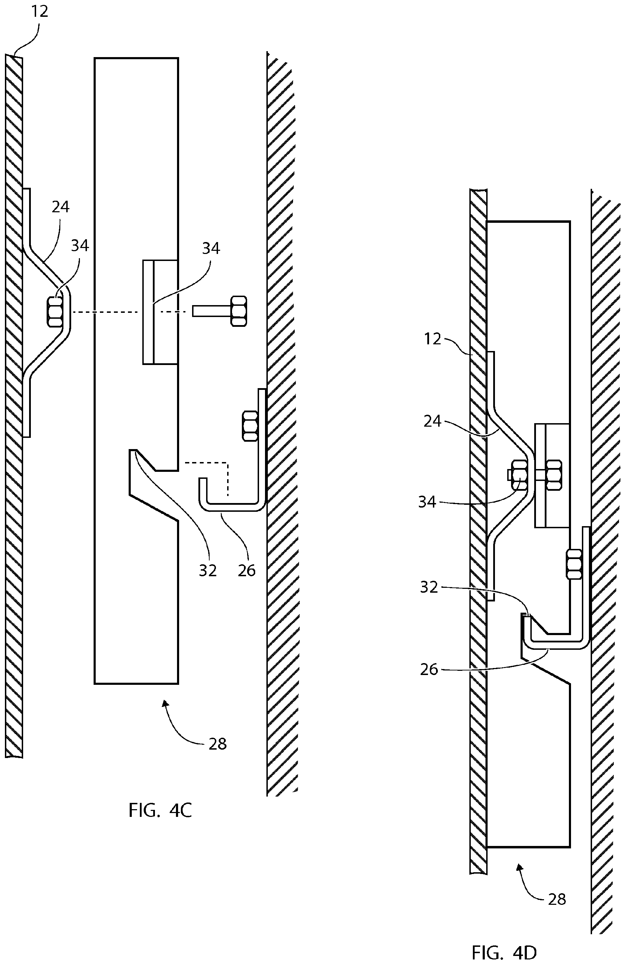

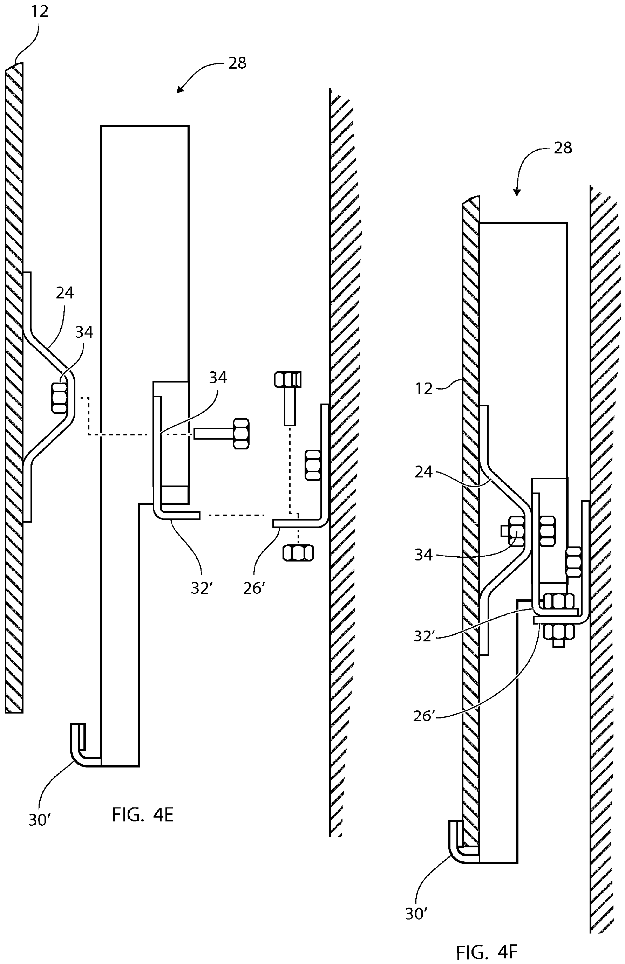

A possible structure combination is shown in figure 4, but not limited to this.

### Summary of the invention

### The invention is defined in the claims.

The above object together with numerous other objects, which are evident from the detailed description of the present invention, are obtained according to a first aspect of the present invention by a solar module comprising photovoltaic cells laminated on a sandwich structure, the sandwich structure providing structural strength to the solar module, the sandwich structure comprising a top plate and a bottom plate both being made of a material with structural strength, the sandwich structure further comprising an inner material located in-between the top plate and the bottom plate.

According to previous technologies, the solar module is attached onto the original roof and/or façade and thus contributes to the total weight of the façade and roof. The added weight of the solar module is typically not envisaged by the building design and thus the building must be reinforced. The solar module according to the present invention is preferably mounted directly onto the load bearing structure of the building and thus used as the actual roof tile and/or façade panel thereby eliminating the need for separate façade panels and roof tiles.

In order to make the above feasible, the solar modules according to the present invention must have a weight per area unit which corresponds to the weight per area unit of conventional roof tiles and the solar modules must be watertight themselves and arranged in a watertight relationship relative to each other.

The conventionally used solar modules having a glass front which is load-bearing is therefore unsuitable or at least very expensive, since it will be heavy and difficult to attach properly to the framework.

The presently suggested sandwich structure is advantageous since it may be constructed very light while providing a high structural strength comparable to conventional façade panels and roof tiles. The top and bottom plates are typically made of a thin but solid and sturdy material of high density such as aluminium whereas the inner material constitutes a filler material interconnecting the top and bottom plates. The inner material has a lower density than the top and bottom plates and may preferably be a hollow structure such as a honeycomb structure or a corrugated structure.

The photovoltaic cells are laminated in an isolated material such as EVA onto the top plate opposite the inner material. A cover, such as a plastic foil, is typically used for protecting the photovoltaic modules from wind, rain and debris.

In the presently suggested solar module, the sandwich structure, not the front plate, is structural load-bearing. Thus, the sandwich structure may be fastened directly to the load-bearing framework of the building. As the sandwich structure is lightweight and may correspond to the weight of conventional façade panels and roof tiles, no reinforcement of the building structure is needed and the entire façade and/or roof may, if desired, be covered by solar modules.

The solar modules should be watertight and be sealed together in a watertight joint in order to provide a proper façade or roof surface.

According to a further embodiment of the first aspect, the top plate and the bottom plate being made of metal such as aluminium, stainless steel, iron or copper, and/or the inner material being made in the form of cells interconnecting said top plate and said bottom plate, such as a corrugated metal core, a sinus plate, a trapezoidal plate, aluminium foam, metal foam, stainless steel foam, a honeycomb structured material, stone wool, Silicon Carbide, Carbon, Fiberglass.

Preferably, one or more of the above-mentioned lightweight materials are used.

According to a further embodiment of the first aspect, the photovoltaic cells being covered by or encapsulated in a transparent front cover made of a transparent film material or constituting a transparent sandwich structure providing thermal insulation for the solar module.

Either a thin foil is used as cover, or alternatively a transparent sandwich structure made of e.g. polymeric material. A transparent sandwich structure may on one hand provide additional structural strength to the solar module, similar to a glass cover, however, it may also provide thermal insulation in order to make the thermal absorber more efficient, as a lot of thermal heat is escaping though the front cover in case it is non-isolated.

According to a further embodiment of the first aspect, the transparent front cover is textured, self-cleaning, anti-reflective or nano-coloured.

A textured front cover may be used for allowing the cover to appear more like conventional roof tiles. The cover may be self-cleaning, e.g. by the use of compressed air for removing debris which otherwise would obscure one or more photovoltaic cells. Anti-reflective coating may be used for increasing the amount of radiation which is received by the photovoltaic cells, and nano-colouring may be used for allowing the solar modules to appear in a colour different from the standard black colour used conventionally.

According to a further embodiment of the first aspect, the solar module comprise bypass diodes laminated in the same layer as the photovoltaic cells.

By the use of bypass diodes, any obscured or broken photovoltaic cell will be bypassed to prevent it from draining energy from the other cells. As the bypass diodes are laminated in the same layer as the photovoltaic cells, a compact unit is achieved. Further, in case during installation one or more photovoltaic cells are broken by being e.g. drilled through, the consequences are just that these cells are not contributing as they are bypassed, however, the other cells are still fully operable.

According to a further embodiment of the first aspect, the bottom plate comprises a hard material profile having flaps, which are laminated or fixed inside a rear part of the solar module.

Using a hard metal profile will allow the solar module to be easily fixated onto a building.

According to a further embodiment of the first aspect, further comprising a wall mount in the form of a rail, which is bolted to a load-bearing part of a building structure, and a connection piece which is bolted onto the hard material profile and which includes a holding member for releasably holding said rail.

Preferably, six hard metal profiles and connection pieces are used per solar module, two at the top, two at the middle and two at the bottom, for a secure and releasable fixture of the solar module onto a wall of a building. Even more preferably, nine hard metal profiles and connection pieces are used per solar module, three at the top, three at the middle and three at the bottom, for an even more secure fixture of the solar module onto a wall of a building

According to a further embodiment of the first aspect, the solar module comprises a thermal absorber, the thermal absorber being laminated onto the sandwich structure, encapsulated in the sandwich structure, welded onto the sandwich structure or forming an integrated part of the sandwich structure, the thermal absorber being thermally connected to a building heating system or building cooling system, optionally via a heat exchanger and/or a heat pump..

Using a thermal absorber allows the solar module to provide thermal energy in addition to electric energy. The thermal absorber is preferably black in order to be able to absorb as much heat from the solar radiation as possible. The thermal absorber may also be used for providing night sky cooling by using the thermal absorber as a black body irradiator during night time when no solar irradiation exist. The thermal absorber may be thermally connected to the sandwich structure or form part of the sandwich structure. For instance, the space in-between the top plate and the bottom plate may be used for circulating a heating/cooling medium. The thermal absorber may preferably be made of aluminium.

Using the thermal absorber for providing building heating or cooling may involve circulating a heating/cooling medium such as water through the thermal absorber. The heating/cooling medium may in this way during daytime absorb thermal energy at the thermal absorber and release the thermal energy inside the building, e.g. by the use of a thermal convector. A heat exchanger and a heat storage tank may be used for e.g. storing hot water for later domestic use or for heating during the night. The heat energy received from the thermal absorber may also be used for pre-heating water for the building central heating system and/or in combination with a heat pump for enhancing the efficiency of the system.

During night time, the process may be reversed in that heat may be absorbed by indoor thermal convectors and release by black body radiation from the thermal absorber. Similarly, the cooling effect may be used later e.g. during the daytime by storing cool water for later use, and the effect may be enhanced by the use of a heat pump.

According to a further embodiment of the first aspect, the solar module comprises programmable Light Emitting Diodes, the programmable Light Emitting Diodes preferably comprise a set of RGB diodes each representing one pixel and together being capable of displaying text messages or images over the whole surface of the solar module.

The solar modules may also be used as environmentally and energy effective big screens by incorporating RGB diodes into the module. During daytime, the solar module may be used for charging a battery with electric energy. The RGB diodes, positioned in-between the photovoltaic cells, may be powered by the battery and controlled by a computer to light up in different colours forming images or text messages similar to a big LCD screen.

According to a further embodiment of the first aspect, the solar module comprises an insulation layer.

The insulation layer may be located on the front side of the solar module provided it is transparent. It may also form part of the sandwich structure, e.g. be part of the inner material of the sandwich. The insulation may also be located at the rear side of the solar module, or a combination of the above. The insulation reduces thermal losses and improves the efficiency of any thermal absorbers, which may be used.

According to a further embodiment of the first aspect, the sandwich structure comprises an intermediate plate being made of a material with structural strength and located within the inner material between the top plate and a bottom plate.

In this way a dual sandwich structure is achieved. In addition, to provide further structural strength to the solar module, the different layers thereby achieved may be used for different purposes. For instance, the space in-between the top plate and the intermediate plate may be used for the thermal absorber by circulating the heating/cooling medium therein, whereas the space in-between the bottom plate and the intermediate plate may be used for thermal insulation.

According to a further embodiment of the first aspect, the top plate and the bottom plate are staggered such that a plurality of solar modules may be connected in a partially overlapping configuration.

In this way the solar modules may be interconnected in a likewise staggered configuration in a roof or façade structure in which the top portion of a higher situated module overlaps the bottom portion of a lower situated solar module. In this way, rainwater running along the outer surface of the solar module will not be able to leak inside into the load bearing structure of the building.

The above object together with numerous other objects which are evident from the detailed description of the present invention are obtained according to a second aspect of the present invention by a building structure having solar modules mounted directly onto the load bearing structure of the building structure as façade or roof elements, the solar modules being mutually interconnected to form a waterproof surface.

The above solar module according to the first aspect is preferably mounted close together to form a unitary and watertight surface on a facade or roof of a building.

The above object together with numerous other objects which are evident from the detailed description of the present invention are obtained according to a third aspect of the present invention by a method of manufacturing a solar module, the method comprising providing a top plate and a bottom plate both being made of a material with structural strength, locating an inner material in-between the top plate and the bottom plate, laminating solar cells and optionally bypass diodes onto the top plate, and preferably covering the solar cells and bypass diodes by a transparent front cover,

The method according to the third aspect is preferably used for manufacturing the solar modules according to the first aspect.

According to a further embodiment, the solar module comprise a battery, the battery thermally contacting the sandwich structure opposite the photovoltaic cells. In this way the battery or batteries may be integrated into the solar module and at the same time be cooled by the same technique as used for cooling the photovoltaic cells, i.e. during the day by circulating a cooling/heating fluid through the sandwich structure and during the night using night sky cooling. The batteries are preferable made flat in order to save space and releasable from the rest of the module in order to be able toi exchange the batteries.

The above object together with numerous other objects which are evident from the detailed description of the present invention are obtained according to a fourth aspect of the present invention by a solar module comprising photovoltaic cells laminated on a thermal absorbing structure, further comprising a battery thermally contacting the thermal absorbing structure opposite the photovoltaic cells. In this way an alternative embodiment is realized having a thermal absorber in which photovoltaic cells are laminated on one side and a battery or batteries are thermally contacting the opposite side. Thus, the the thermal absorber may be used for cooling both the photovoltaic cells and the battery.

### Brief description of the drawings

FIG. 1A is a perspective view of a building having façade mounted solar modules during the day.
FIG. 1B is a perspective view of a building having façade mounted solar modules during the night.
FIG. 1C is a perspective view of a building having façade mounted solar modules.
FIG. 2A is a side view of a sandwich structure having a corrugated or sinus shaped interior.
FIG. 2B is a perspective view of a sandwich structure having a corrugated or sinus shaped interior.
FIG. 2C is a side view of a sandwich structure having a trapezoid shaped interior.
FIG. 2D is a perspective view of a sandwich structure having a trapezoid shaped interior.
FIG. 2E is a side view of a sandwich structure having a rectangular shaped interior.
FIG. 2F is a perspective view of a sandwich structure having a rectangular shaped interior.
FIG. 3A is a side view of a solar module with a metal profile having a trapezoid shape.
FIG. 3B is a side view of a metal profile having a trapezoid shape.
FIG. 3C is a side view of a solar module with a metal profile having a rectangular shape.
FIG. 3D is a side view of a metal profile having a rectangular shape.
FIG. 3E is a side view of a solar module with a metal profile having an omega shape.
FIG. 3F is a side view of a metal profile having an omega shape.
FIG. 4A is a blown-up side view of an upper mounting system.
FIG. 4B is a side view of an upper mounting system when mounted.
FIG. 4C is a blown-up side view of a middle mounting system.
FIG. 4D is a side view of a middle mounting system when mounted.
FIG. 4E is a blown-up side view of a lower mounting system.
FIG. 4F is a side view of a lower mounting system when mounted.
FIG. 5A is a side view of a solar module having a load-bearing sandwich structure.
FIG. 5B is a perspective view of a solar module having a load-bearing sandwich structure.
FIG. 6A is a side view of a solar module having a sandwich structure as a cover.
FIG. 6B is a perspective view of a solar module having a sandwich structure as a cover.
FIG. 7A is a side view of a solar module with a sandwich structure as cover and load-bearing capabilities.
FIG. 7B is a perspective view of a solar module with a sandwich structure as cover and load-bearing capabilities.
FIG. 8A is a side view of a solar module having a sandwich structure and a thermal absorber.
FIG. 8B is a perspective view of a solar module having a sandwich structure and a thermal absorber.
FIG. 9A is a side view of a solar module having a staggered sandwich structure.
FIG. 9B is a perspective view of a solar module having a staggered sandwich structure.
FIG. 9C is a perspective view of a roof made of solar modules.
FIG. 10 is a side view of a solar module having a copper absorber.
FIG. 11 is a side view of a solar module having an aluminium absorber.
FIG. 12 is a perspective view of a piping system.
FIG. 13 is a perspective view of a heating system having a heat exchanger.
FIG. 14 is a perspective view of a heating system having a heat pump.
FIG. 15 is a perspective view of a cooling system.
FIG. 16 shows a side view of a solar module having a copper absorber and batteries.
FIG. 17 shows a side view of a solar module having an aluminium absorber and batteries.
FIG. 18 shows a side view of a solar module having an aluminium absorber, a sandwich structure and batteries.

### Detailed description of the drawings

FIG. 1A shows a perspective view of a building 10 having façade-mounted solar modules 12. During the day, the solar modules 12 generate electrical energy, which may be stored in battery modules (not shown) or fed to the grid. Additionally, the solar modules 12 may produce thermal energy, which may be used directly for domestic heating purposes or stored for later use in the building.

FIG. 1B shows a perspective view of the building 10 having façade-mounted solar modules 12'. The solar modules 12' may have integrated LEDs, which may form a big screen for displaying images or texts. Further, during the night, the solar modules may be used for night sky cooling of the building 12.

FIG. 1C shows a perspective view of a building 10' having roof-mounted solar panels 12. The panels are mounted onto the load-bearing structure of the building, in place of roof tiles.

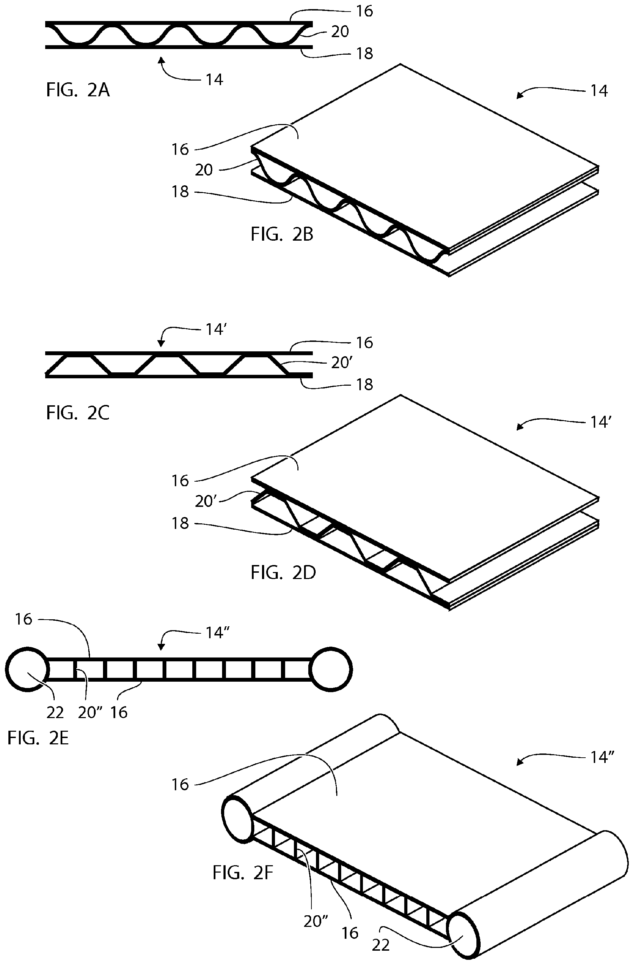

FIG. 2A shows a side view of a sandwich structure 14. The sandwich structure comprises a top plate 16 and a bottom plate 18 made of a material having a structural strength, preferably aluminium. The sandwich structure 14 has a corrugated or sinus-shaped interior 20 interconnecting the top plate 16 and the bottom plate 18 in order to form a cell structure, which provides structural strength for the sandwich structure 14. The corrugated or sinus-shaped interior 20 may be made of aluminium, preferably extruded aluminium.

FIG. 2B shows a perspective view of the above sandwich structure 14 having a corrugated or sinus-shaped interior 20.

FIG. 2C shows a side view of a sandwich structure 20' having a trapezoid shaped interior 20' similar to the previous embodiment.

FIG. 2D shows a perspective view of the sandwich structure 14' having a trapezoid shaped interior 20'.

FIG. 2E shows a side view of a sandwich structure 14" having a rectangular-shaped interior 20" similar to the previous embodiment, and additionally being provided with pipes 22 for circulating cooling or heating fluids, such as water and/or glycol.

FIG. 2F shows a perspective view of the sandwich structure 14" having a rectangular-shaped interior 20".

FIG. 3A shows a side view of a solar module with a metal profile 24 having a trapezoid shape. The metal profile 24 have flaps which are laminated or welded onto the bottom plate 18 of the sandwich structure, thereby providing a suitable fastening mechanism for the solar module. The metal profile is preferably made of a hard and durable metal.

FIG. 3B shows a side view of the metal profile 24 having a trapezoid shape, without the bottom plate of the sandwich structure.

FIG. 3C shows a side view of a solar module with a metal profile 24' having a rectangular shape, similar to the previous embodiment.

FIG. 3D shows a side view of the metal profile 24' having a rectangular shape, without the bottom plate of the sandwich structure.

FIG. 3E shows a side view of a solar module with a metal profile having an omega shape, similar to the previous embodiment.

FIG. 3F shows a side view of the metal profile 24"having an omega shape, without the bottom plate of the sandwich structure.

FIG. 4A shows a blown- up side view of an upper mounting system. The mount for a complete solar module preferably comprises a total of nine mounting systems, three upper, three middle and three lower. The mounting system comprises a metal profile 24 as described above, which is welded or laminated onto the bottom plate of the sandwich of the solar module 12. A rail 26 is screwfastened to the wall of the building. A connecting member 28 is used for interconnecting the metal profile 24 and the rail 26. The connecting member 28 comprises a frame 30, which forms the top part of the outer frame of the module 12. The connecting member 28 further comprises a holding part, which catches the rail 26. The metal profile 24 is fixated to the connecting member 28 via a screw mount 34.

FIG. 4B shows a side view of the upper mounting system when mounted on the wall of a building.

FIG. 4C shows a blown- up side view of a middle mounting system, similar to the previous embodiment.

FIG. 4D shows a side view of a middle mounting system when mounted on the wall of a building.

FIG. 4E shows a blown- up side view of a lower mounting system, similar to the previous embodiment. The frame 30' forms the lower part of the outer frame of the module 12. The rail 26' is fixated to the connecting member 28 via a screw mount.

FIG. 4F shows a side view of a lower mounting system when mounted on the wall of a building.

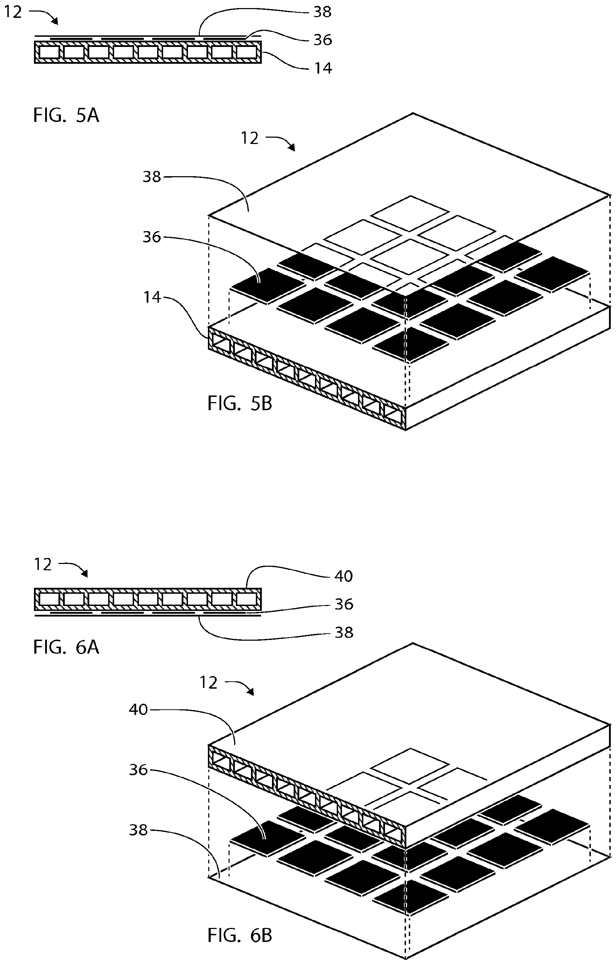

FIG. 5A shows a side view of a solar module having a load-bearing sandwich structure 14. The solar module further comprises photovoltaic cells 36, which are laminated onto the sandwich structure 14 by the use of e.g. glue or EVA. The photovoltaic cells 36 are protected by a foil 38 of a transparent plastic material.

FIG. 5B shows a perspective view of the solar module 12 having a load-bearing sandwich structure 14.

FIG. 6A shows a side view of a solar module 12 having a transparent sandwich structure as a cover 40. The sandwich structure as a cover may be load-bearing, however, it may also be used for providing thermal insulation to the solar module 12, or both. Aluminium cannot be used as it is opaque and thus glass or plastic are feasible materials. The backing plate 38 is in the present embodiment made of a foil or plate material, such as plastic or metal.

FIG. 6B shows a perspective view of the solar module 12 having a transparent sandwich structure as a cover 40.

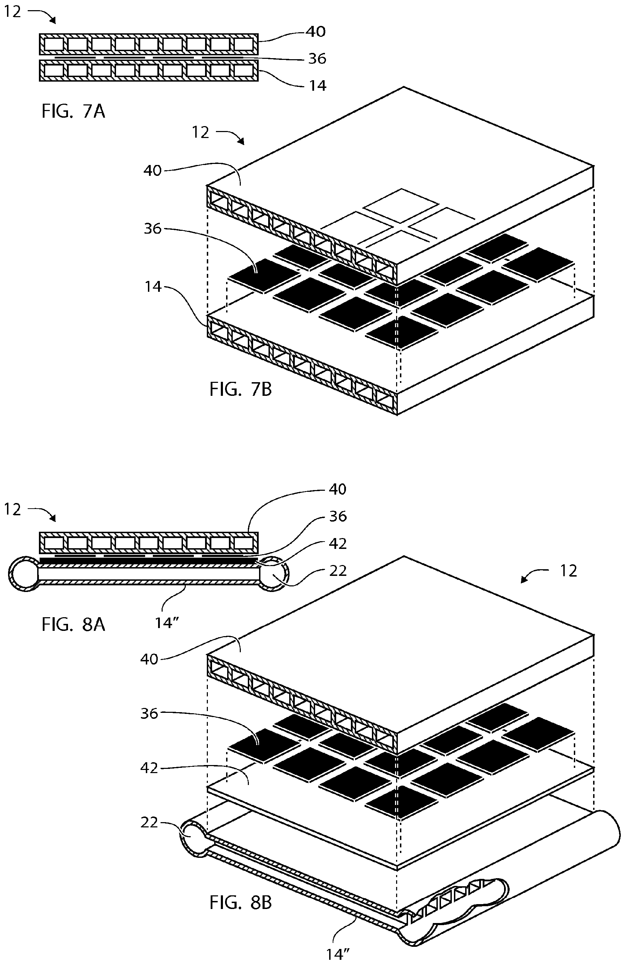

FIG. 7A shows a side view of a solar module 12 with a sandwich structure as cover 40 and a loadbearing sandwich structure 14 made of e.g. aluminium located on the opposite side, whereby the photovoltaic cells 36 are located in-between the cover 40 and the load-bearing sandwich structure 14.

FIG. 7B shows a perspective view of a solar module 12 with a sandwich structure as cover 40 and load-bearing sandwich structure 14 located opposite the cover 40.

FIG. 8A shows a side view of a solar module 12 having a sandwich structure 14 and thermal absorber 42. It should hereby be noted that the thermal absorber 42 must not be a separate part but may be omitted or it may be integrated into sandwich structure 14. The thermal absorber 42 and the sandwich structure 14 may thus form a unitary element. The thermal absorber preferably has a black colour in order to efficiently absorb heat energy. A heating (or cooling) fluid such as water or glycol is thereby circulated through the cells of the inner structure of the sandwich structure 14, between the upper plate and the lower plate. The cells of the sandwich structure 14 are connected to a respective inlet and outlet manifold or pipe 22, whereby the fluid heats up (or cools down) a few degrees centigrade by passing though the cells of the sandwich structure 14. The temperature of the circulating fluid may vary depending on the actual application, and temperatures between -5 degrees centigrade and 90 degrees centigrade are feasible. A normal value would be about 25 degrees centigrade. The fluid may also contribute to the cooling of the photovoltaic modules 36. The optional cover 40 of a transparent sandwich material may be used to reduce thermal losses. The pipe 22 is here made circular, it may however also be square, rectangular or any other appropriate shape.

FIG. 8B shows a perspective view of a solar module 12 having a sandwich structure 14 and thermal absorber 42.

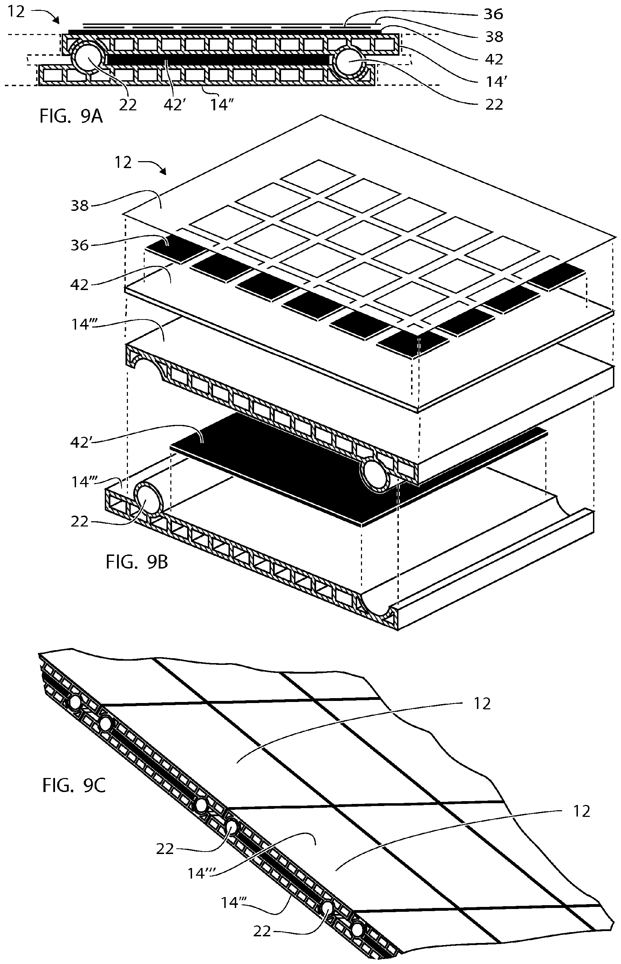

FIG. 9A shows a side view of a solar module 12 having a staggered sandwich structure 14' 14". The staggered sandwich structure comprises an upper sandwich structure 14' and a lower sandwich structure 14" which are adhered together in a partially overlapping and partially non-overlapping structure.

FIG. 9B shows a perspective view of a solar module 12 having a staggered sandwich structure.

FIG. 9C shows a perspective view of a roof made of the above-mentioned solar modules having a staggered sandwich structure. The solar modules may thereby be placed as roof tiles such that the part of each sandwich structure where the upper sandwich structure 14' and the lower sandwich structure 14" are not overlapping themselves instead are overlapping a part of a sandwich structure of an adjacent solar module. In this way, the roof may be made fully rain proof, similar to conventional roof tiles. Additionally, the module may be sealed together forming a fully waterproof surface.

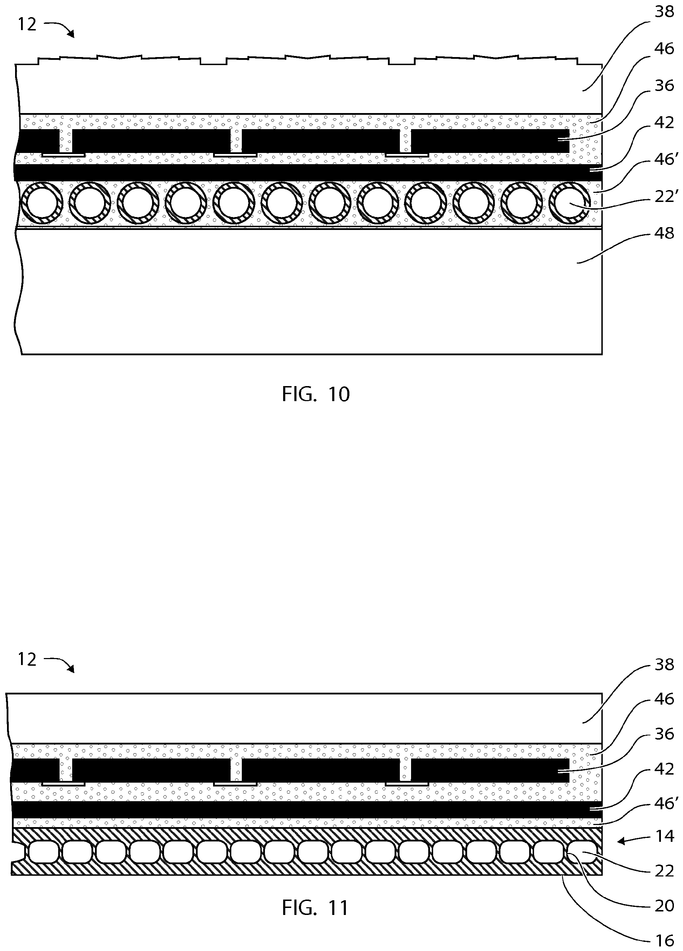

FIG. 10 shows a side view of a solar module having a copper absorber. Copper absorbers have conventionally been used together with copper pipes 22' for collecting thermal energy. Copper has a superior thermal conductivity. The photovoltaic cells 36 are encapsulated in EVA.

FIG. 11 shows a side view of a solar module. Aluminium also has a very high thermal conductivity and is easier to extrude into a sandwich structure. The advantage of the present embodiment is that the sandwich structure is used both as structurally load-bearing elements and as fluid channels for transporting the absorbed heat. The photovoltaic cells 36 are encapsulated in EVA.

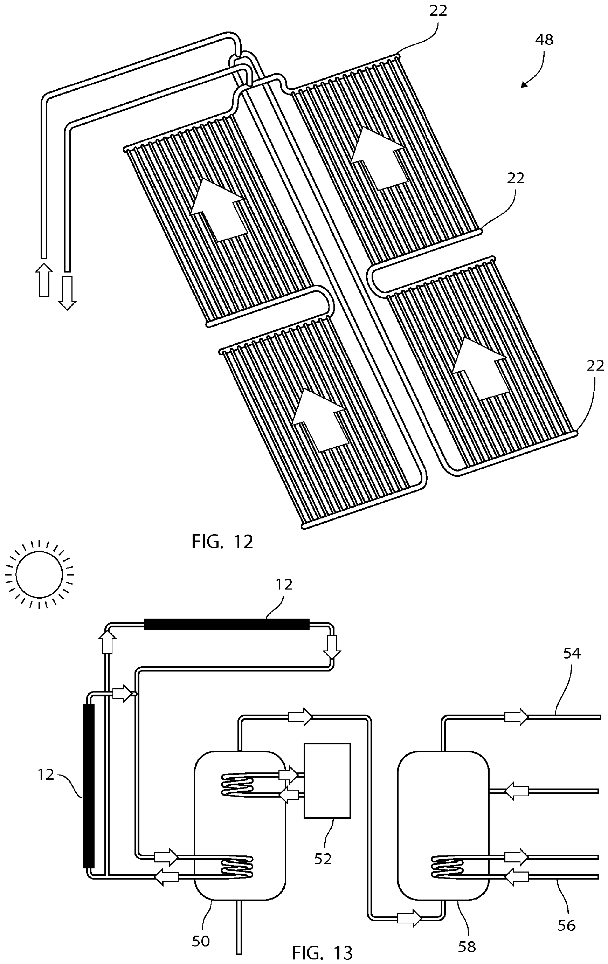

FIG. 12 shows a perspective view of a piping system 48. Manifolds or pipes 22 feed each of the solar modules with fluid. The fluid flows through the solar module in the cells of the sandwich structure and is then returned for collecting the heat energy thereby obtained.

FIG. 13 shows a perspective view of a heating system having a heat exchanger 50. A fluid such as water or glycol is fed through the solar panels 12. A heat exchanger 50 is used for collecting the thermal energy collected by the modules, which corresponds to the temperature difference between the fluid flowing into the heat exchanger 50 and the fluid flowing out of the heat exchanger 50. The heat exchanger is in turn connected to a domestic water tank 58 of a building for heating water used for central heating 56 or other domestic purposes. As the efficiency of the solar panels is improved using temperatures of about 25 degrees centigrade compared to domestic water tanks, which normally use temperatures of about 50 centigrade to avoid contamination by microorganism, an additional heater 52 may be required such that the solar modules provide a pre-heating of the water and the further heating is made by another heating system.

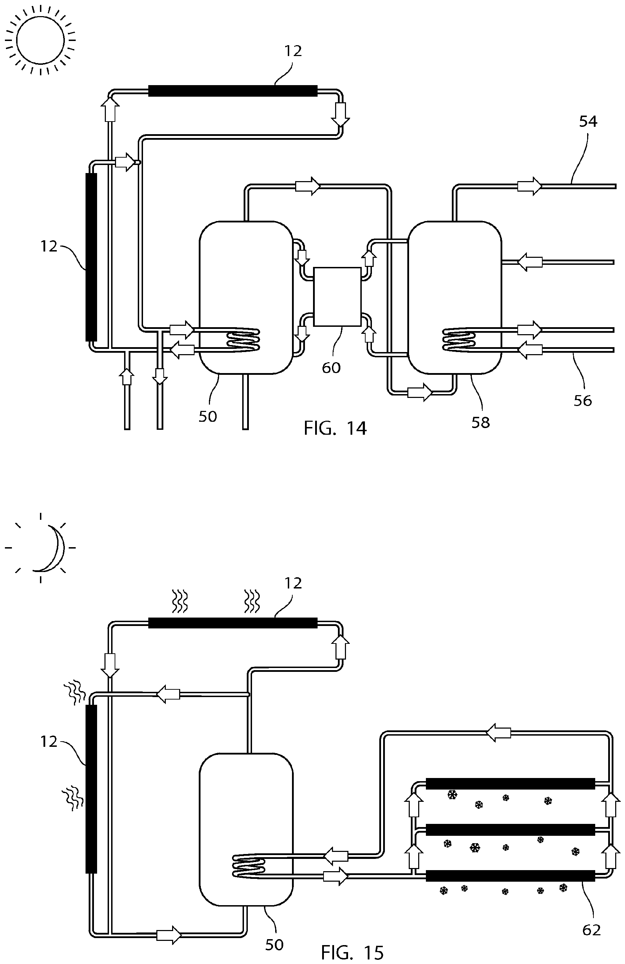

FIG. 14 shows a perspective view of a heating system which instead of using an additional heater uses a heat pump 60 for raising the temperature of the circulating fluid from about 25 degrees centigrade, which is suitable for obtaining solar heat and cool the photovoltaic cells, to about 50 degrees centigrade which is suitable as domestic hot water.

FIG. 15 shows a perspective view of a cooling system which may be used when no incoming solar radiation exist for obtaining night sky cooling. In this way, a fluid such as water or glycol is circulated through the solar panels releasing heat such that the temperature of the fluid returning from the solar cells is lower that the fluid flowing into the solar cells. The temperature difference may be collected by a heat exchanger and used in a domestic air conditioning system for providing cooling via air convectors 62.

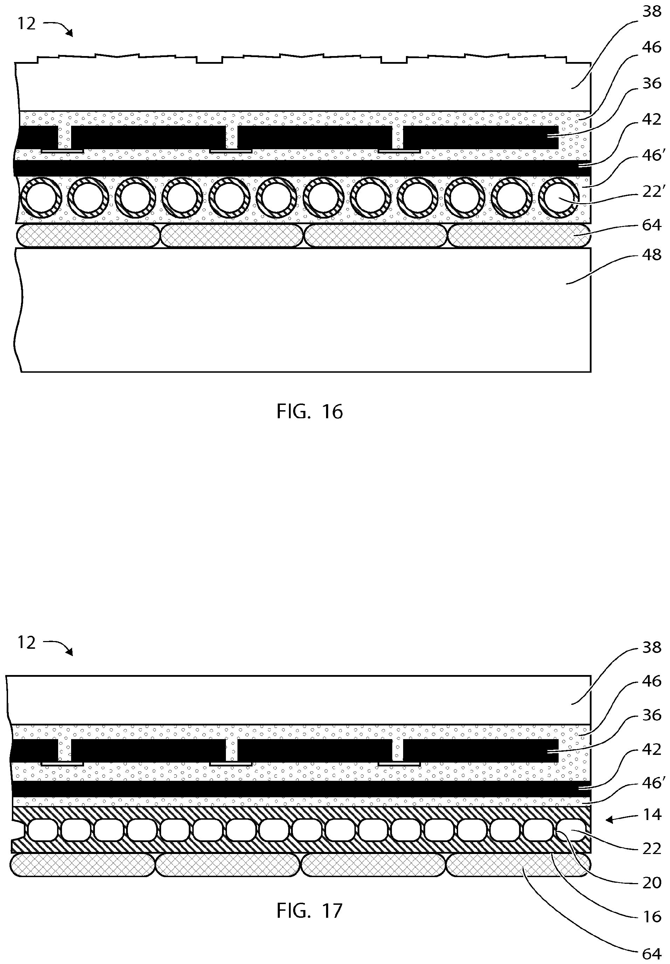

FIG. 16 shows a side view of a solar module 12 having a copper absorber including copper pipes 22' and batteries 64. The batteries 64 are in the present embodiment located between the absorber including the copper pipes 22' and the rear insulation. The batteries have thermal contact to the absorber and thus indirectly to the copper pipes 22' and the photovoltaic cells 36. The batteries 64 may preferably be releasably attached to the absorber e.g. by beings clamped to the copper absorber or a pocket providing a tight fit and this good thermal conductivity between the thermal absorber and the batteries 64. The batteries 64 may thus be easily exchanged when needed.

According to the present embodiment, the batteries 64 form an integrated part of the solar module 12 and may be electrically connected to the photovoltaic cells 36 for allowing the photovoltatic cells 36 to charge the batteries 64 during the day. The batteries may be used for various purposes including various needs of the building such as for powering heating units, cooling units, ventilation units or other devices such as computers etc. The batteries may further e.g. be used to charge electrical vehicles or light up diodes during the night as described above. The batteries 64 may be e.g. lithium batteries.

The batteries 64 are cooled during the day by the cooling fluid circulating in the copper pipes 22' in the same way as the photovoltaic cells 36 are cooled as described above, and the thermal energy may be collected and used for various purposes as described above such a building heating or domestic water heating. During the night, the batteries may be directly cooled by the use of night sky cooling as described above, i.e. the radiant energy from the solar module 12 facing the night sky will yield a cooling effect on the solar module 12.

FIG. 17 shows a side view of a solar module 12 similar to the previous embodiment, in which the copper tubing is replaced by the aluminium profile 20. Thus, as previously described, the present embodiment provides both a structurally load-bearing elements and as fluid channels for transporting the absorbed heat. The batteries 64 are placed in thermal contact with the aluminium profile 20. Cooling/heating liquid may be circulated through the pipes 22.

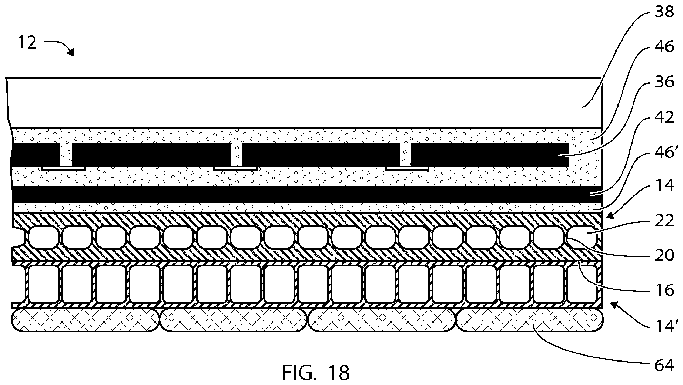

FIG. 18 shows a side view of a solar module 12 having an aluminium absorber 20, a sandwich structure 14' and batteries. Inbetween the aluminium heat absorber 20 and the batteries 64 a reinforcing sandwish structure 14' made of heat conductive material such as metal may be used. In this way, the solar module may be fastened to a load bearing structure without interfering with the aluminium absorber 20. Combinations of the above mentioned embodiments are of course equally feasible.

**Reference numerals used in the figures**

| | |
|---|---|
| 10. Building | 38. Foil |
| 12. Solar module | 40. Cover |
| 14. Sandwich structure | 42. Thermal absorber |
| 16. Top plate | 44. Insulation |
| 18. Bottom plate | 46. EVA |
| 20. Inner material | 48. Pipe system |
| 22. Pipe | 50. Heat exchanger |
| 24. Profile | 52. Heater |
| 26. Rail | 54. Domestic hot water |
| 28. Connecting member | 56. Central heating |
| 30. Frame | 58. Domestic boiler |
| 32. Holding part | 60, Heat pump |
| 34. Screw mount | 62. Cooling convector |
| 36. Photovoltaic cells | 64. Battery |

## Claims

1. A solar module (12) comprising photovoltaic cells laminated on a sandwich structure (14), said sandwich structure (14) providing structural strength to said solar module (12), said sandwich structure (14) comprising a top plate (16) and a bottom plate (18), said sandwich structure (14) further comprising an inner material (20) located inbetween said top plate (16) and said bottom plate (18), and being provided with pipes (22) for circulating cooling or heating fluids and said solar module (12) comprising a battery (64), said battery thermally contacting said sandwich structure (14) opposite said photovoltaic cells,
**characterized in that** said top plate (16) and said bottom plate (18) are both made of a material with structural strength, so that said module (12) can be used without other supportive measures such as a glass or aluminium frame.

2. The solar module (12) according to claim 1, wherein said top plate (16) and said bottom plate (18) being made of metal such as aluminium, stainless steel, iron or copper, and/or said inner material being made in the form of cells interconnecting said top plate and said bottom plate (18), such as a corrugated metal core, a sinus plate, a trapezoidal plate, aluminium foam, metal foam, stainless steel foam, a honeycomb structured material, stone wool, Silicon Carbide, Carbon, Fiberglass.

3. The solar module (12) according to any of the preceding claims, wherein said photovoltaic cells being covered by or encapsulated in a transparent front cover made of a transparent film material or constituting a transparent sandwich structure (14) providing thermal insulation for said solar module.

4. The solar module (12) according to claim 3, wherein said transparent front cover is textured, self-cleaning or anti-reflective.

5. The solar module (12) according to any of the preceding claims, wherein said solar module (12) comprise bypass diodes laminated in the same layer as the photovoltaic cells.

6. The solar module (12) according to any of the preceding claims, wherein said bottom plate (18) comprises a hard material profile having flaps which are laminated or fixed inside a rear part of the solar module (12).

7. The solar module (12) according to claim 6, further comprising a wall mount in the form of a rail which is bolted to a load-bearing part of a building structure, and a connection piece which is bolted onto the hard material profile and which includes a holding member for releasably holding said rail.

8. The solar module (12) according to any of the preceding claims, wherein said solar module (12) comprises a thermal absorber (42), said thermal absorber (42) being laminated onto said sandwich structure (14), encapsulated in said sandwich structure (14), welded onto said sandwich structure (14) or forming an integrated part of said sandwich structure (14), said thermal absorber (42) being thermally connected to a building heating system or building cooling system, optionally via a heat exchanger (50) and/or a heat pump (60).

9. The solar module (12) according to any of the preceding claims, wherein said solar module (12) comprises programmable Light Emitting Diodes, said programmable Light Emitting Diodes preferably comprise a set of RGB diodes each representing one pixel and together being capable of displaying text messages or images over the whole surface of the solar module.

10. The solar module (12) according to any of the preceding claims, wherein said solar module (12) comprises an insulation layer

11. The solar module (12) according to any of the preceding claims, wherein said solar module (12) comprises battery storage and/or hot/cold water storage.

12. The solar module according to any of the preceding claims, wherein said sandwich structure (14) comprises an intermediate plate being made of a material with structural strength, so that said solar module (12) can be used without other supportive measures, such as a glass or aluminium frame, and located within said inner material between said top plate (16) and a bottom plate (18).

13. The solar module (12) according to claim 12, wherein said top plate (16) and said bottom plate (18) are staggered such that a plurality of solar modules (12) may be connected in a partially overlapping configuration.

14. A building structure having solar modules (12) according to any of the preceding claims mounted directly onto the load-bearing structure of the building structure as façade or roof elements, said solar modules being mutually interconnected to form a waterproof surface.

## Patentansprüche

1. Solarmodul (12), das photovoltaische Zellen umfasst, die auf eine Sandwichstruktur (14) laminiert sind, wobei die Sandwichstruktur (14) dem Solarmodul (12) strukturelle Festigkeit verleiht, **dadurch gekennzeichnet, dass** die Sandwichstruktur (14) eine Deckplatte (16) und eine Bodenplatte (18) umfasst, die beide aus einem Material mit struktureller Festigkeit gefertigt sind, sodass das Solarmodul (12) ohne weitere unterstützende Vorkehrungen, wie etwa Glas- oder Aluminiumrahmen, verwendet werden kann, wobei die Sandwichstruktur (14) ferner ein Innenmaterial (20), das sich zwischen der Deckplatte (16) und der Bodenplatte (18) befindet, umfasst und mit Rohren (22) zum Zirkulieren von Kühl- oder Heizfluiden versehen ist und das Solarmodul (12) eine Batterie (64) umfasst, wobei die Batterie die Sandwichstruktur (14) gegenüber den photovoltaischen Zellen thermisch kontaktiert.

2. Solarmodul (12) nach Anspruch 1, wobei die Deckplatte (16) und die Bodenplatte (18) aus Metall, wie etwa Aluminium, Edelstahl, Eisen oder Kupfer, gefertigt sind, und/oder wobei das Innenmaterial in Form von Zellen gefertigt ist, die die Deckplatte und die Bodenplatte (18) miteinander verbinden, wie etwa ein gewellter Metallkern, eine Sinusplatte, eine trapezförmige Platte, Aluminiumschaum, Metallschaum, Edelstahlschaum, ein Material mit Wabenstruktur, Steinwolle, Siliziumkarbid, Kohlenstoff, Fiberglas.

3. Solarmodul (12) nach einem der vorstehenden Ansprüche, wobei die photovoltaischen Zellen durch eine transparente Frontabdeckung, die aus einem transparenten Folienmaterial gefertigt ist, bedeckt oder darin eingekapselt sind oder eine transparente Sandwichstruktur (14) bilden, die eine Wärmeisolierung für das Solarmodul bereitstellt.

4. Solarmodul (12) nach Anspruch 3, wobei die transparente Frontabdeckung strukturiert, selbstreinigend oder antireflektierend ist.

5. Solarmodul (12) nach einem der vorstehenden Ansprüche, wobei das Solarmodul (12) Bypass-Dioden umfasst, die in derselben Schicht wie die Photovoltaikzellen laminiert sind.

6. Solarmodul (12) nach einem der vorstehenden Ansprüche, wobei die Bodenplatte (18) ein Hartmaterialprofil mit Laschen umfasst, die innerhalb eines hinteren Teils des Solarmoduls (12) laminiert oder befestigt sind.

7. Solarmodul (12) nach Anspruch 6, ferner umfassend eine Wandhalterung in Form einer Schiene, die an ein tragendes Teil einer Gebäudestruktur geschraubt ist, und ein Verbindungsstück, das auf das Hartmaterialprofil geschraubt ist und das ein Halteelement zum lösbaren Halten der Schiene beinhaltet.

8. Solarmodul (12) nach einem der vorstehenden Ansprüche, wobei das Solarmodul (12) einen Wärmeabsorber (42) umfasst, wobei der Wärmeabsorber (42) auf die Sandwichstruktur (14) laminiert ist, in der Sandwichstruktur (14) eingekapselt ist, an die Sandwichstruktur (14) geschweißt ist oder einen integrierten Bestandteil der Sandwichstruktur (14) bildet, wobei der Wärmeabsorber (42) mit einem Gebäudeheizsystem oder Gebäudekühlsystem thermisch verbunden ist, optional über einen Wärmetauscher (50) und/oder eine Wärmepumpe (60).

9. Solarmodul (12) nach einem der vorstehenden Ansprüche, wobei das Solarmodul (12) programmierbare Leuchtdioden umfasst, wobei die programmierbaren Leuchtdioden vorzugsweise einen Satz von RGB-Dioden umfassen, die jeweils ein Pixel darstellen und zusammen Textnachrichten oder Bilder über die gesamte Oberfläche des Solarmoduls anzeigen können.

10. Solarmodul (12) nach einem der vorstehenden Ansprüche, wobei das Solarmodul (12) eine Isolierungsschicht umfasst.

11. Solarmodul (12) nach einem der vorstehenden Ansprüche, wobei das Solarmodul (12) einen Batteriespeicher und/oder einen Heiß-/Kaltwasserspeicher umfasst.

12. Solarmodul nach einem der vorstehenden Ansprüche, wobei die Sandwichstruktur (14) eine Zwischenplatte umfasst, die aus einem Material mit struktureller Festigkeit gefertigt ist, sodass das Solarmodul (12) ohne weitere unterstützende Vorkehrungen, wie etwa einen Glas- oder Aluminiumrahmen, verwendet werden kann und sich innerhalb des Innenmaterials zwischen der Deckplatte (16) und einer Bodenplatte (18) befindet.

13. Solarmodul (12) nach Anspruch 12, wobei die Deckplatte (16) und die Bodenplatte (18) derart versetzt sind, dass eine Vielzahl von Solarmodulen (12) in einer teilweise überlappenden Konfiguration verbunden sein kann.

14. Gebäudestruktur mit Solarmodulen (12) nach einem der vorstehenden Ansprüche, die als Fassaden- oder Dachelemente direkt auf die tragende Struktur der Gebäudestruktur montiert sind, wobei die Solarmodule miteinander verbunden sind, um eine wasserdichte Oberfläche zu bilden.

## Revendications

1. Module solaire (12) comprenant des cellules photovoltaïques stratifiées sur une structure superposée (14), ladite structure superposée (14) fournissant une résistance structurelle audit module solaire (12), ladite structure superposée (14) comprenant une plaque supérieure (16) et une plaque inférieure (18), ladite structure superposée (14) comprenant en outre un matériau interne (20) situé entre ladite plaque supérieure (16) et ladite plaque inférieure (18), et étant pourvue de tuyaux (22) pour faire circuler des fluides de refroidissement ou de chauffage et ledit module solaire (12) comprenant une batterie (64), ladite batterie étant en contact thermique avec ladite structure superposée (14) à l'opposé desdites cellules photovoltaïques, **caractérisé en ce que** ladite plaque supérieure (16) et ladite plaque inférieure (18) sont toutes deux réalisées en un matériau à résistance structurelle, de sorte que ledit module (12) puisse être utilisé sans autres mesures de support, telles qu'un cadre en verre ou en aluminium.

2. Module solaire (12) selon la revendication 1, dans lequel ladite plaque supérieure (16) et ladite plaque inférieure (18) sont réalisées en métal tel que l'aluminium, l'acier inoxydable, le fer ou le cuivre, et/ou ledit matériau interne est réalisé sous la forme de cellules interconnectant ladite plaque supérieure et ladite plaque inférieure (18), telles qu'un noyau métallique ondulé, une plaque sinusoïdale, une plaque trapézoïdale, une mousse d'aluminium, une mousse métallique, une mousse d'acier inoxydable, un matériau à structure en nid d'abeille, la laine de roche, le carbure de silicium, le carbone, des fibres de verre.

3. Module solaire (12) selon l'une quelconque des revendications précédentes, dans lequel lesdites cellules photovoltaïques sont couvertes par ou encapsulées dans un couvercle avant transparent réalisé en un matériau de film transparent ou constituant une structure superposée transparente (14) fournissant une isolation thermique pour ledit module solaire.

4. Module solaire (12) selon la revendication 3, dans lequel ledit couvercle avant transparent est texturé, autonettoyant ou antireflet.

5. Module solaire (12) selon l'une quelconque des revendications précédentes, dans lequel ledit module solaire (12) comprend des diodes de dérivation stratifiées dans la même couche que les cellules photovoltaïques.

6. Module solaire (12) selon l'une quelconque des revendications précédentes, dans lequel ladite plaque inférieure (18) comprend un profil en matériau dur ayant des rabats qui sont stratifiés ou fixés à l'intérieur d'une partie arrière du module solaire (12).

7. Module solaire (12) selon la revendication 6, comprenant en outre un support mural sous la forme d'un rail qui est boulonné à une partie porteuse de charge d'une structure de bâtiment, et une pièce de liaison qui est boulonnée sur le profil en matériau dur et qui comporte un élément de maintien pour maintenir de manière amovible ledit rail.

8. Module solaire (12) selon l'une quelconque des revendications précédentes, dans lequel ledit module solaire (12) comprend un absorbeur thermique (42), ledit absorbeur thermique (42) étant stratifié sur ladite structure superposée (14), encapsulé dans ladite structure superposée (14), soudé sur ladite structure superposée (14) ou faisant partie intégrante de ladite structure superposée (14), ledit absorbeur thermique (42) étant relié thermiquement à un système de chauffage de bâtiment ou à un système de refroidissement de bâtiment, éventuellement par l'intermédiaire d'un échangeur de chaleur (50) et/ou d'une pompe à chaleur (60).

9. Module solaire (12) selon l'une quelconque des revendications précédentes, dans lequel ledit module solaire (12) comprend des diodes électroluminescentes programmables, lesdites diodes électroluminescentes programmables comprennent de préférence un ensemble de diodes RVB représentant chacune un pixel et étant ensemble capables d'afficher des messages texte ou des images sur toute la surface du module solaire.

10. Module solaire (12) selon l'une quelconque des revendications précédentes, dans lequel ledit module solaire (12) comprend une couche isolante.

11. Module solaire (12) selon l'une quelconque des revendications précédentes, dans lequel ledit module solaire (12) comprend un accumulateur et/ou un dispositif de stockage d'eau froide/chaude.

12. Module solaire selon l'une quelconque des revendications précédentes, dans lequel ladite structure superposée (14) comprend une plaque intermédiaire réalisée en un matériau à résistance structurelle, de sorte que ledit module solaire (12) puisse être utilisé sans autres mesures de support, telles qu'un cadre en verre ou en aluminium, et située à l'intérieur dudit matériau interne entre ladite plaque supérieure (16) et une plaque inférieure (18).

13. Module solaire (12) selon la revendication 12, dans lequel ladite plaque supérieure (16) et ladite plaque inférieure (18) sont décalées de sorte qu'une pluralité de modules solaires (12) puisse être connectée dans une configuration partiellement superposée.

14. Structure de bâtiment ayant des modules solaires (12) selon l'une quelconque des revendications précédentes montés directement sur la structure porteuse de charge de la structure de bâtiment en tant qu'éléments de façade ou de toit, lesdits modules solaires étant mutuellement interconnectés pour former une surface étanche.
